**Europäisches Patentamt**

**European Patent Office**

**Office européen des brevets**

(11) Veröffentlichungsnummer: **0 253 914**

**A1**

(12) **EUROPÄISCHE PATENTANMELDUNG**

(21) Anmeldenummer: **86110105.3**

(22) Anmeldetag: **23.07.86**

(51) Int. Cl.⁴: **H03K 19/00** , **H03K 5/02**

Die Bezeichnung der Erfindung wurde geändert (Richtlinien für die Prüfung im EPA, A-III, 7.3).

(43) Veröffentlichungstag der Anmeldung:
**27.01.88 Patentblatt 88/04**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(72) Erfinder: **Gollinger, Wolfgang, Dipl.-Ing.**
**R. Schneider-Strasse 18A**
**D-7803 Gundelfingen(DE)**

(74) Vertreter: **Morstadt, Volker, Dipl.-Ing.**
**c/o Deutsche ITT Industries GmbH**
**Patent/Lizenzabteilung Postfach 840**
**Hans-Bunte-Strasse 19**
**D-7800 Freiburg/Brsg.(DE)**

(54) **Isolierschicht-Feldeffekttransistor-Gegentakttreiberstufe mit Kompensierung von Betriebsparameterschwankungen und Fertigungsstreuungen.**

(57) Diese Treiberschaltung (dc) ist als Teil einer monolithisch integrierten Schaltung realisiert und enthält mehrere zwischen den beiden Polen (+u, -u) der Betriebsspannungsquelle liegende, die gesteuerten Strompfade des oberen und des unteren Transistors (to, tu) enthaltende Serienschaltungen (s1...sn), deren Mittelabgriff (m) mit dem kapazitiv belasteten Schaltungspunkt (k) verbunden ist. Den Gates der Transistoren (tu, to) ist je ein aus dem von der Treiberschaltung (dc) zu übertragenden Digitalsignal (ns) abgeleitetes Steuersignal (cs) zugeführt, das mittels der Steuerschaltung (ss) auch aus dem als Maß für die Schaltverzögerung einer Serienschaltung dienenden Regelsignal (rs) und aus dem Taktsignal (ts) der integrierten Schaltung so erzeugt wird, daß die Transistoren (to, tu) die Funktion eines Tristate-Inverters ausführen können. Somit werden in Abhängigkeit vom Regelsignal mehr oder weniger Serienschaltungen dem Signalweg zu-bzw. von ihm abgeschaltet.

Fig. 1

Fig. 2

## Isolierschicht-Feldeffekttransistor-Gegentakttreiberschaltung

Die Erfindung betrifft Isolierschicht-Feldeffekttransistor-Gegentakttreiberschaltungen, die Teil einer monolithisch integrierten Schaltung sind, mit mindestens einer aus zwischen den beiden Polen einer Betriebsspannungsquelle liegenden, die gesteuerten Strompfade eines oberen und eines unteren Transistors enthaltenden Serienschaltung, deren Mittelabgriff mit einem kapazitiv belasteten Schaltungspunkt verbunden ist und bei der den Gates der Transistoren je ein aus einem von der Treiberschaltung zu übertragenden Digitalsignal abgeleitetes Steuersignal zugeführt ist, vgl. den Oberbegriff des Anspruchs 1.

Das Prinzip einer derartigen Treiberschaltung ist beispielsweise in der europäischen Patentanmeldung EP-A 55 795 entsprechend der US-PS 44 77 735 dahingehend vorbeschrieben, daß man sie zur Ansteuerung von kapazitiv belasteten Schaltungspunkten benötigt, wenn die Kapazität des Schaltungspunkts so groß ist, daß die steilen Flanken eines aus einer gegebenen Signalquelle stammenden Digitalsignals unzulässig abgeflacht werden, was eine Vergrößerung der Signalverzögerungszeit der Treiberstufe bedeutet.

Im Gegensatz zu der vorbeschriebenen Anordnung beschäftigt sich die Erfindung jedoch nicht mit diesem, sondern mit folgendem Problem: Bekanntlich bedingt die Aufladung eines Kondensators einen Impulsstrom, dessen Amplitude direkt und dessen Breite umgekehrt proportional zur Flankensteilheit des Aufladeimpulses, also des zu übertragenden Digitalsignals, ist. Die Oberwellen dieser Impulsströme sind umso energiereicher, je höher die Amplitude des Impulsstroms ist, was zu erhöhter Störstrahlung oder Störbeeinflussung innerhalb der integrierten Schaltung führt. Andererseits ist für ein sicheres Funktionieren der integrierten Schaltung eine Mindestflankensteilheit erforderlich. Die Flankensteilheit der von der oben vorausgesetzten Treiberschaltung abgegebenen Signale ist nun aber von den Betriebsparametern der einzelnen integrierten Schaltung, wie z.B. Betriebstemperatur und Betriebsspannung, sowie von den Fertigungsschwankungen der einzelnen integrierten Schaltungen untereinander abhängig. Die Worst-case-Dimensionierung bedingt daher eine Flankensteilheitsreserve, die aber zu den erwähnten steilen und schmalen Impulsströmen führt.

Der in den Ansprüchen gekennzeichneten Erfindung liegt somit die Aufgabe zugrunde, die eingangs umschriebene Treiberschaltung so auszubilden, daß die erwähnte Abhängigkeit von Betriebsparameterschwankungen und die erwähnten Fertigungsstreuungen bei jeder einzelnen integrierten Schaltung weitgehend kompensiert sind. Der Grundgedanke der Erfindung besteht darin, mittels eines in der jeweiligen integrierten Schaltung selbst gewonnenen Signals, das als Maß für die von einer Treiberschaltung ermöglichte Flankensteilheit dient, in Bezug auf ein die integrierte Schaltung versorgendes oder steuerndes Taktsignal ein Regelsignal zu gewinnen, das es ermöglicht, mehrere der eingangs definierten Serienschaltungen, deren jeweiliger Ausgang mit dem kapazitiv belasteten Schaltungspunkt verbunden ist, gleichzeitig in den Weg des zu übertragenden Digitalsignals zu legen und dadurch die insgesamt wirksame W/L-Dimensionierung (siehe unten) der Serienschaltung dem jeweiligen Betriebszustand anzupassen.

Als bevorzugtes Maß für die Flankensteilheit, die im wesentlichen proportional zu Schaltverzögerung einer Treiberschaltung ist dient die Frequenz des Oszillatorsignals einer auf der integrierten Schaltung ausgebildeten ungeraden Anzahl von ring-geschalteten Invertern, also eines sogenannten Ringoszillators.

Die Erfindung wird nun anhand der Figuren der Zeichnung näher erläutert.

Fig. 1 zeigt ein stark schematisiertes Schaltbild des der Erfindung zugrundeliegenden Prinzips,

Fig. 2 zeigt als Blockschaltbild eine bevorzugte Ausführungsform,

Fig. 3 zeigt eine Weiterbildung der Anordnung nach Fig. 2,

Fig. 4 zeigt eine Weiterbildung der Anordnung nach Fig. 3,

Fig. 5 zeigt u.a. das Schaltbild einer zur Ansteuerung von Serienschaltungen aus n-Kanal-Enhancement-Transistoren dienenden Verknüpfungslogik,

Fig. 6 zeigt das Schaltbild einer ersten Variante der Verknüpfungslogik zur Ansteuerung von in CMOS-Technik realisierten Serienschaltungen, und

Fig. 7 zeigt das Schaltbild einer zweiten Variante zur Ansteuerung von CMOS-Serienschaltungen.

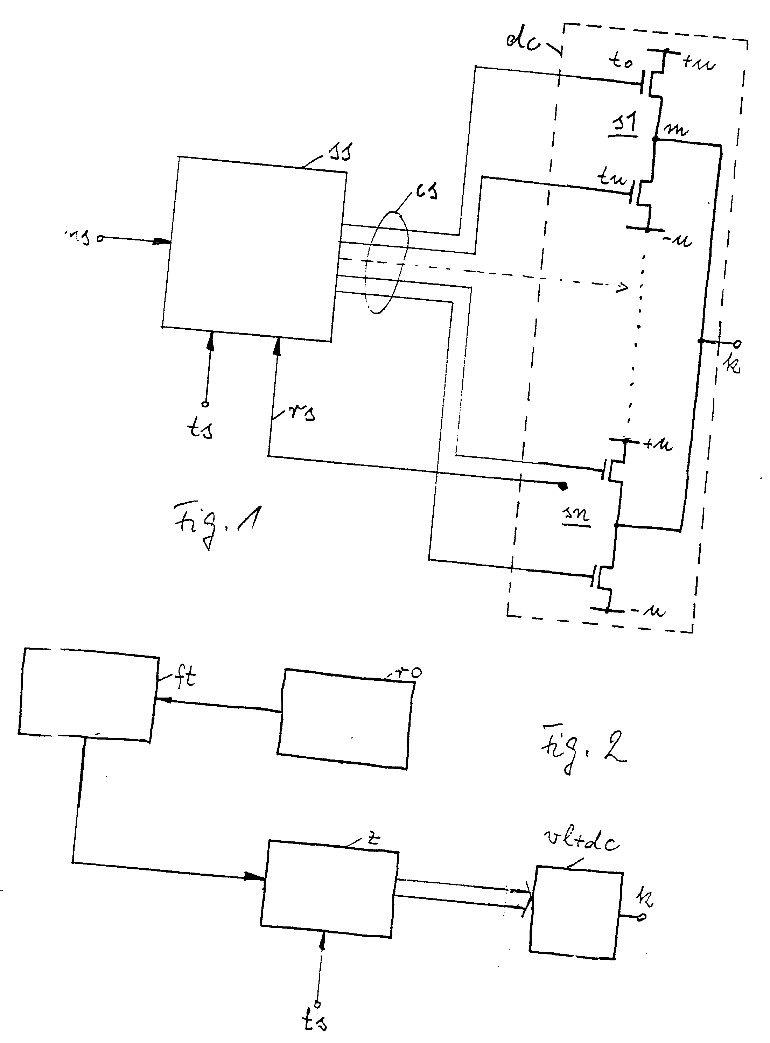

Das stark schematisierte Schaltbild der Fig. 1 enthält die Treiberstufe dc, die ihrerseits eine Anzahl n von Serienschaltungen des gesteuerten Strompfads des oberen Transistors to und des unteren Transistors tu umfaßt, die zwischen den beiden Polen +u, -u der Betriebsspannungsquelle liegen. Von den n Serienschaltungen sind die erste s1 und die letzte sn in Fig. 1 gezeigt. Der jeweilige Mittelabgriff m dieser Serienschaltungen und somit deren jeweiliger Ausgang ist mit dem kapazitiv belasteten Schaltungspunkt k fest verbunden, so daß die einzelnen Serienschaltungen bezüglich dieses Schaltungspunkts parallelliegen.

Die Steuerschaltung ss erzeugt das Steuersignal cs für die Gates der beiden Transistoren jeder Serienschaltung s1...sn aus dem zum Schaltungspunkt k zu übertragenden Digitalsignal ns, dem Taktsignal ts der integrierten Schaltung und dem als Maß für die Schaltverzögerung (Flankensteilheit) einer Serienschaltung dienenden Regelsignal rs. In Fig. 1 ist die letztere Tatsache dadurch symbolisiert, daß in der Nähe der letzten Serienschaltung sn ein Abnahmepunkt für die zur Steuerschaltung ss führende Verbindungsleitung gezeichnet ist. Als Digitalsignal ns kann bevorzugt auch das Taktsignal ts dienen.

Die Dimensionierung der einzelnen Serienschaltungen s1.. .sn kann dem jeweiligen Anwendungsfall in verschiedener Weise angepaßt werden. So ist es beispielsweise möglich, die einzelnen Serienschaltungen s1...sn hinsichtlich des jeweiligen Längen-Breiten-Verhältnisses (= W/L-Verhältnis) identisch zu dimensionieren, so daß das Gesamt-W/L-Verhältnis, wenn alle n Serienschaltungen in den Signalweg eingeschaltet sind, nW/L beträgt, während bei weniger in den Signalweg geschalteten Serienschaltungen die Anzahl der gerade eingeschalteten als Multiplikationsfaktor für das einfache W/L-Verhältnis das wirksame W/L-Verhältnis bestimmt.

In anderen Anwendungsfällen kann es sinnvoll sein, insbesondere wenn mittels der integrierten Schaltung in einem bestimmten Binärcode vorliegende Digitalsignale verarbeitet werden, die W/L-Verhältnisse der einzelnen Serienschaltungen entsprechend der Wertigkeit dieses Binärcodes abgestuft zu wählen. Im einfachsten Fall des natürlichen Dualcodes ist also, ausgehend von beispielsweise der ersten Serienschaltung s1, das W/L-Verhältnis jeder weiteren Serienschaltung um den Faktor 2 größer als das der jeweils vorausgehenden Serienschaltung.

Die Steuerschaltung ss erzeugt das Steuersignal cs für die Gates der Transistoren der einzelnen Serienschaltungen s1...sn derart, daß jede Serienschaltung nicht nur das zu übertragende Digitalsignal überträgt, sondern daß sie auch in einen nichtübertragenden Zustand gebracht werden können, d.h. jede Serienschaltung s1...sn kann die drei folgenden Schaltzustände annehmen: 1. : oberer Transistor leitend und unterer Transistor gesperrt; 2. : oberer Transistor gesperrt und unterer Transistor leitend; 3. : oberer und unterer Transistor gleichzeitig gesperrt. Die Ansteuerung der einzelnen Serienschaltungen erfolgt somit derart, daß sie jeweils wie ein sogenannter Tristate-Inverter wirken können.

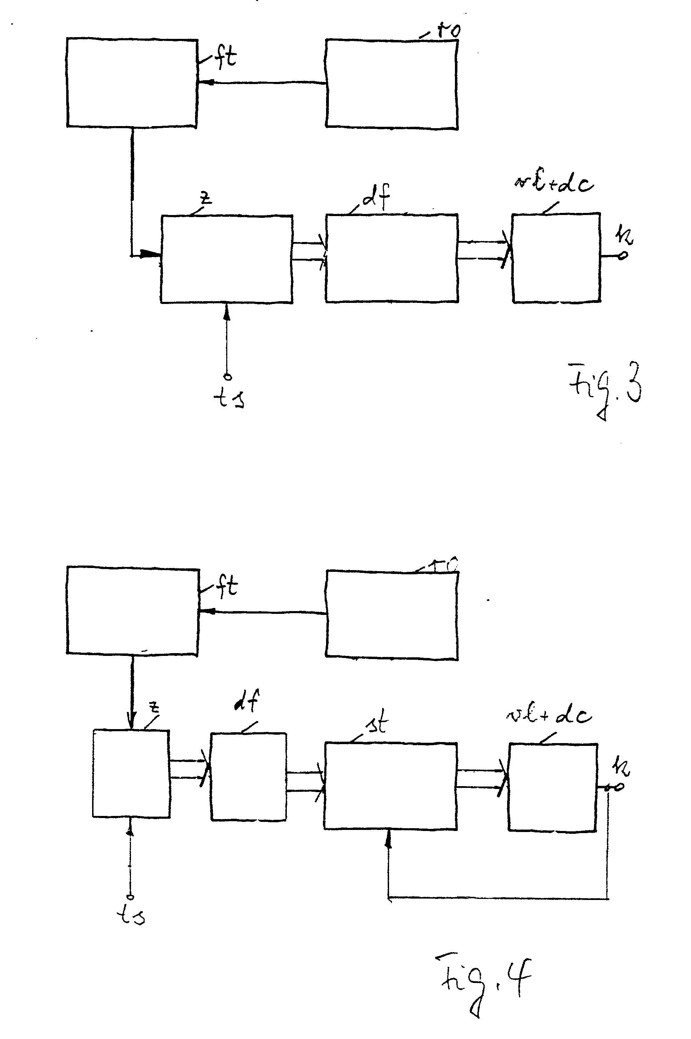

Die Fig. 2 zeigt ein stark schematisiertes Blockschaltbild der bereits erwähnten bevorzugten Ausführungsform der Erfindung, bei der als Maß für die Schaltverzögerung der Serienschaltungen s1...sn die Frequenz des Oszillatorsignals einer ungeraden Anzahl von ringgeschalteten Invertern, also die des Ringoszillators ro, im Vergleich zur Frequenz des Taktsignals ts dient. Die Frequenz derartiger Ringoszillatoren hängt zwar von der Anzahl der ringgeschalteten Inverter ab, da sie im wesentlichen umgekehrt proportional zu der Gesamtverzögerungszeit der Ringschaltung ist, ist jedoch andererseits von den Betriebsparametern der integrierten Schaltung, auf der der Ringoszillator sich befindet, und auch von den eingangs erwähnten Fertigungsschwankungen in gleicher Weise wie die Schaltverzögerung der Serienschaltungen s1...sn abhängig.

Das Oszillatorsignal ist dem Frequenzteiler ft zugeführt und dessen Ausgangssignal dem Enable-Eingang des Zählers z. Der Frequenzteiler ft erzeugt somit in Abhängigkeit von der gewählten Beschaltung seines Ausgangs ein mit der Oszillatorfrequenz des Ringoszillators ro in festem Verhältnis stehendes Zeitfenster, während dem die dem Zähleingang des Zählers zugeführten Impulse des Taktsignals ts gezählt werden. Der in den Zählpausen am Ausgang des Zählers z auftretende Zählerstand ist somit ein Maß für die momentane Oszillatorfrequenz des Ringoszillators ro. Die einzelnen Zählerstandausgänge des Zählers z sind in noch zu erläuternder Abhängigkeit von den Realisierungsvarianten der einzelnen Serienschaltungen über die Verknüpfungslogik vl den Gates der oberen und unteren Transistoren to, tu der Serienschaltungen s1...sn zugeführt. Dabei werden sowohl die nichtinvertierten als auch die invertierten Ausgangssignale dieser Zählerstandausgänge benutzt.

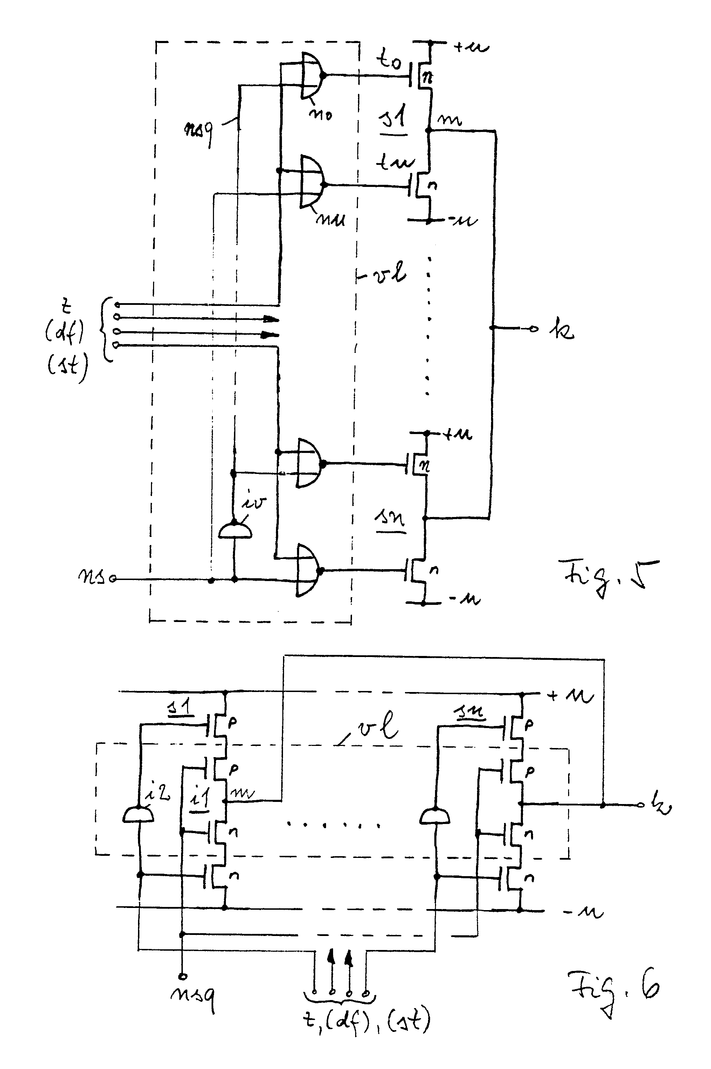

Die Fig. 3 zeigt eine Weiterbildung der bevorzugten Ausführungsform nach Fig. 2, und zwar ist zwischen der Verknüpfungslogik vl und den Zählerstandausgängen des Zählers z das Digitalfilter df eingefügt. Dieses Digitalfilter hat die Funktion eines Tiefpasses, der Schwankungen der Schaltverzögerung, die sonst durch kurzzeitige Änderungen der Ringoszillatorfrequenz verursacht würden, unterdrückt.

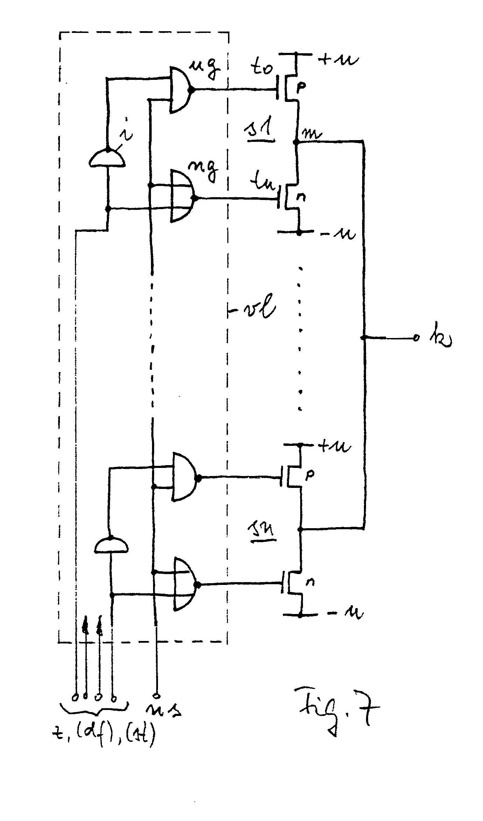

In Fig. 4 ist eine weitere Variante der Ausführungsform nach Fig. 2 gezeigt, und zwar in Weiterbildung der Anordnung nach Fig. 2 die Synchronisierstufe st, die zwischen den Ausgang des Digitalfilters df und den Eingang der Verknüpfungslogik vl geschaltet ist und zur Synchronisierung mit dem Signal des Schaltungspunkts k dient.

Die Fig. 5 zeigt die Ausgestaltung der Verknüpfungslogik vl für den Fall, daß die Serienschaltung s1...sn mittels n-Kanal-Enhancement-Transistoren zu realisieren sind. Die Verknüpfungslogik vl besteht pro Serienschaltung aus je einem das jeweilige Gate von deren Transistoren to, tu ansteuernden oberen bzw. unteren NOR-Gatter no, nu mit jeweils zwei Eingängen. Dem ersten Eingang des unteren NOR-Gatters nu ist das Digitalsignal ns und dem des oberen NOR-Gatters no das invertierte Digitalsignal nsq zugeführt. Diese Invertierung kann beispielsweise durch den in Fig. 5 innerhalb der Verknüpfungslogik vl gezeigten Inverter iv erreicht werden. Auf den Inverter iv kann selbstverständlich verzichtet werden, wenn innerhalb der integrierten Schaltung das Digitalsignal ns auch in seiner invertierten Form nsq anderweitig zur Verfügung steht. Die zweiten Eingänge der jeder Serienschaltung s1...sn zugeordneten beiden NOR-Gatter no, nu sind vom invertierten Ausgangssignal eines der Zählerstandausgänge des Zählers z angesteuert.

Ist beispielsweise der Zähler z ein Binärzähler und sind die W/L-Verhältnisse der einzelnen Serienschaltungen s1...sn, wie bereits erwähnt, untereinander jeweils um den Faktor 2 verschieden, so sind die beiden NOR-Gatter der ersten Serienschaltung s1 mit der niederstwertigen Stelle und die der letzten Serienschaltung sn mit der höchstwertigen Stelle des Zählerstandausgangs des Zählers z zu verbinden, und zwar wiederum mit solchen Schaltungspunkten, die das invertierte Ausgangssignal abgeben.

In Fig. 5 ist durch die an den diesbezüglichen Klemmen der NOR-Gatter in Klammern angegebenen Bezugszeichen veranschaulicht, daß bei Vorhandensein des Digitalfilters df nach Fig. 3 oder der Synchronisierstufe st nach Fig. 4 die entsprechenden Ausgänge dieser Teilschaltungen mit den NOR-Gatter-Eingängen zu verbinden sind.

Die Fig. 6 zeigt eine erste Variante der Verknüpfungslogik vl für den Fall, daß die integrierte Schaltung mit der Treiberschaltung und deren Serienschaltungen in CMOS-Technik realisiert ist. In diesem Fall ist der obere Transistor ein p-Transistor und der untere ein n-Transistor. Die Verknüpfungslogik vl besteht in Fig. 6 aus dem ersten (CMOS)-Inverter i1, der mit seinem gesteuerten Strompfad zwischen dem p-und dem n-Transistor eingefügt ist und dessen Eingang das invertierte Digitalsignal nsq zugeführt ist sowie dessen Ausgang am Schaltungspunkt k liegt. Ferner besteht die Verknüpfungslogik vl aus dem dem Gate des p-Transistors vorgeschalteten zweiten Inverter i2, dessen Eingang zusammen mit dem Gate des n-Transistors das Ausgangssignal eines der Zählerstandausgänge des Zählers z zugeführt ist.

Das W/L-Verhältnis der Transistoren des ersten Inverters i1 ist dabei jeweils gleich dem der einzelnen Serienschaltung s1...sn im oben angegebenen Sinne zu wählen.

Da dies z.B. für die erwähnte Abstufung um den Faktor 2 schon bei wenigen Serienschaltungen dazu führt, daß der Flächenbedarf sehr stark zunimmt, zeigt Fig. 7 eine andere Variante, die zwar hinsichtlich der Verknüpfungslogik vl einen größeren Aufwand an Einzelstufen erfordert, jedoch insbesondere bei der erwähnten Abstufung um den Faktor 2 bei größerer Anzahl n insgesamt weniger Flächenbedarf aufweist.

In Fig. 7 besteht die Verknüpfungslogik vl pro Serienschaltung s1...sn aus dem das Gate des p-Transistors ansteuernden NAND-Gatter ug mit zwei Eingängen, dem das Gate des n-Transistors ansteuernden NOR-Gatter ng mit zwei Eingängen und dem Inverter i. Dem jeweils ersten Eingang des NAND-Gatters ug und des NOR-Gatters ng ist das Digitalsignal ns zugeführt. Für jede Serienschaltung s1...sn sind der zweite Eingang des NOR-Gatters ng und über den Inverter i der zweite Eingang des NAND-Gatters ug vom invertierten Ausgangssignal eines der Zählerstandausgänge des Zählers z angesteuert.

Da bei steigender Temperatur die Frequenz des Oszillatorssignals des Ringoszillators ro abnimmt und somit dessen Periodendauer größer wird, erreicht der Zähler z höhere Zählerstände als bei niedrigen Temperaturen, und es werden somit mehr Serienschaltungen dem Signalweg zugeschaltet als bei niederen Temperaturen. Insgesamt wird somit die wirksame Verzögerungszeit bei steigender Temperatur der integrierten Schaltung auf dem Sollwert gehalten.

In umgekehrter Weise verhält sich die Anordnung nach der Erfindung bei Erhöhung der Betriebsspannung. Dann steigt die Oszillatorfrequenz, und es fallen somit weniger Taktsignalimpulse in das Zeitfenster, so daß der Zähler einen niedrigeren Zählerstand erreicht als bei niedriger Betriebsspannung. Somit werden auch weniger Serienschaltungen dem Signalweg zugeschaltet, und der Sollwert der Verzögerung der Treiberschaltung bleibt erhalten. Diese Betriebsspannungsabhängigkeit liegt allerdings bei N-Kanal-Depletion-Load-Schaltungen nicht vor, da diese durch die Stromquellen-Wirkung des Depletion-Transistors als Lastimpedanz des/der Schalttransistors/transistoren weitgehend unabhängig von Betriebsspannungsschwankungen sind, im Gegensatz zu z.B. CMOS-Schaltungen.

Nach einer weiteren Ausgestaltung der Erfindung, die jedoch in den Figuren der Zeichnung nicht dargestellt ist, kann jede Serienschaltung s1...sn von einer üblichen Bootstrapschaltung angesteuert sein, oder sie kann selbst Teil einer derartigen Bootstrapschaltung sein, wenn die Serienschaltungen in n-Kanal-Enhancement-Technik realisiert sind. Derartige Bootstrapschaltungen sind bei n-Kanalschaltungen seit langem geläufig, um den oberen Pegel des Ausgangssignals möglichst nahe an den Spannungswert des positiven Pols +u der Betriebsspannungsquelle anzunähern. Die Verknüpfunglogik vl nach Fig. 5 ist dann jeweils in Abhängigkeit von der gewählten Art der Bootstrapschaltung vereinfachbar; es muß lediglich die erwähnte Funktion der Zu-und Abschaltung von einzelnen Serienschaltungen zum oder vom Signalweg gewährleistet sein.

## Ansprüche

1. Isolierschicht-Feldeffekttransistor-Gegentakttreiberschaltung (= Treiberschaltung) (dc) als Teil einer monolithisch integrierten Schaltung mit mindestens einer zwischen den beiden Polen (+u, -u) einer Betriebsspannungsquelle liegenden, die gesteuerten Strompfade eines oberen und eines unteren Transistors (to, tu) enthaltenden Serienschaltung (s...), deren Mittelabgriff (m) mit einem kapazitiv belasteten Schaltungspunkt (k) verbunden ist und bei der den Gates der Transistoren (to, tu) je ein aus einem von der Treiberschaltung (dc) zu übertragenden Digitalsignal (ns) abgeleitetes Steuersignal (cs) zugeführt ist, dadurch gekennzeichnet,
-daß mehrere Serienschaltungen (s1...sn) mit ihrem Mittelabgriff (m) am Schaltungspunkt (k) liegen und
-daß eine Steuerschaltung (ss) das Steuersignal (cs) aus dem Digitalsignal (ns) und aus einem als Maß für die Schaltverzögerung einer Serienschaltung dienenden Regelsignal (rs) sowie aus einem Taktsignal (ts) der integrierten Schaltung derart erzeugt, daß
--die Transistoren (to, tu) jeder Serienschaltung (s1...sn) einen der drei folgenden Schaltzustände annehmen: 1.: obere(r) Transistor(en) leitend und untere(r) Transistor(en) gesperrt; 2.: obere(r) Transistor(en) gesperrt und untere(r) Transistor(en) leitend; 3.: obere(r) und untere(r) Transistor(en) gleichzeitig gesperrt).

2. Treiberschaltung nach Anspruch 1, dadurch gekennzeichnet, daß als Maß für die Schaltverzögerung die Frequenz des Oszillatorsignals einer ungeraden Anzahl von ring-geschalteten Invertern (= Ringoszillator) (ro) im Vergleich zur Frequenz des Taktsignals (ts) dient.

3. Treiberschaltung nach Anspruch 1 oder 2, dadurch gekennzeichnet, daß das Oszillatorsignal einem Frequenzteiler (ft) zugeführt ist, dessen Ausgang am Enable-Eingang eines Zählers (z) liegt, dessen Zähleingang mit dem Taktsignal (ts) gespeist ist und dessen Zählerstandausgänge mit einer Verknüpfungslogik (vl) zur Ansteuerung der Serienschaltungen (s1...sn) verbunden sind.

4. Treiberschaltung nach Anspruch 3 mit n-Kanal-Enhancement-Transistoren, gekennzeichnet durch folgende Merkmale:
- die Verknüpfungslogik (vl) besteht pro Serienschaltung (s1...sn) aus je einem das jeweilige Gate von deren Transistoren ansteuernden oberen bzw. unteren NOR-Gatter (no,nu) mit zwei Eingängen,
-dem ersten Eingang des unteren NOR-Gatters (nu) ist das Digitalsignal (ns) und dem des oberen NOR-Gatters (no) das invertierte Digitalsignal (nsq) zugeführt, und -die zweiten Eingänge der beiden NOR-Gätter einer Serienschaltung sind vom invertierten Ausgangssignal eines der Zählerstandausgänge des Zählers (z) angesteuert.

5. Treiberschaltung nach Anspruch 4, dadurch gekennzeichnet, daß jede Serienschaltung (s1...sn) von einer Bootstrap-Schaltung angesteuert oder selbst Teil einer Bootstrap-Schaltung ist.

6. Treiberschaltung nach Anspruch 3 in CMOS-Technik mit einem p-Transistor als oberem und einem n-Transistor als unterem Transistor, gekennzeichnet durch folgende Merkmale:
-die Verknüpfungslogik (vl) besteht pro Serienschaltung (s1...sn) aus einem das Gate des p-Transistors ansteuernden NAND-Gatter (ug) mit zwei Eingängen, einem das Gate des n-Transistors ansteuernden NOR-Gatter (ng) mit zwei Eingängen und einem Inverter (i),
-dem ersten Eingang des NAND-Gatters (ug) und dem des NOR-Gatters (ng) ist das Digitalsignal (ns) zugeführt, und
-für jede Serienschaltung sind der zweite Eingang des NOR-Gatters (ng) und über den Inverter (i) der zweite Eingang des NAND-Gatters (ug) vom invertierten Ausgangssignal eines der Zählerstandausgänge des Zählers (z) angesteuert.

7. Treiberschaltung nach Anspruch 3 in CMOS-Technik mit einem p-Transistor als oberem und einem n-Transistor als unterem Transistor, dadurch gekennzeichnet, daß die Verknüpfungslogik (vl) pro Serienschaltung (s1...sn) aus seinem mit einem gesteuerten Strompfad zwischen dem p-und dem n-Transistor eingefügten ersten Inverter (i1), dessen Eingang das invertierte Digitalsignal (nsq) zugeführt ist und dessen Ausgang am Schaltungspunkt (k) liegt, und einem das Gate des p-Transistors vorgeschalteten zweiten Inverter (i2) besteht, dessen Eingang zusammen mit dem Gate des n-Transistors das Ausgangssignal eines der Zählerstandausgänge des Zählers (z) zugeführt ist.

8. Treiberschaltung nach einem der Ansprüche 1 bis 7, dadurch gekennzeichnet, daß als Digitalsignal (ns) das Taktsignal (ts) dient.

9. Treiberschaltung nach einem der Ansprüche 1 bis 8, dadurch gekennzeichnet, daß zwischen der Verknüpfungslogik (vl) und den Zählerstandausgängen des Zählers (z) ein Digitalfilter (df) angeordnet ist.

10. Treiberschaltung nach Anspruch 9, dadurch gekennzeichnet, daß dem Digitalfilter (df) eine Synchronisierstufe (st) zur Synchronisierung mit dem Signal des Schaltungspunkts (k) nachgeschaltet ist.

Fig. 1

Fig. 2

ft

ro

vl+dc

z

df

ts

k

Fig.3

ft

ro

df

st

vl+dc

z

ts

k

Fig.4

Fig. 5

Fig. 6

Fig. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 184 875 (N.V. PHILIPS' GLOEILAMPENFABRIEKEN) <br> * Zusammenfassung; Figuren 1-3; Seite 1, Zeile 1 - Seite 7, Zeile 34; Anspruch 1 * <br><br> --- | 1-3 | H 03 K 19/00 <br> H 03 K 5/02 |
| Y | US-A-3 996 481 (CHU et al.) <br> * Zusammenfassung; Figuren 10,11; Spalte 1, Zeilen 5-11; Spalte 6, Zeile 53 - Spalte 7, Zeile 37 * <br><br> --- | 1-3 | |
| A | IBM TECHNICAL DISCLOSURE BULLETIN, Band 24, Nr. 5, Oktober 1981, Seiten 2558,2559, New York, US; W.R. GRIFFIN et al.: "High speed complementary driver circuit" <br> * Insgesamt * <br><br> --- | 1,6,7 | |
| A | EP-A-0 181 047 (LSI LOGIC CORP.) <br> * Zusammenfassung; Figuren 1,2,4; Seite 2, Zeile 10 - Seite 3, Zeile 11; Seite 3, Zeile 30 - Seite 6, Zeile 24 * <br><br> ---     -/- | 1,2 | RECHERCHIERTE SACHGEBIETE (Int. Cl.4) <br><br> H 03 K <br> H 03 F |

Der vorliegende Recherchenbericht wurde für alle Patentansprüche erstellt.

| Recherchenort | Abschlußdatum der Recherche | Prüfer |
|---|---|---|
| DEN HAAG | 24-03-1987 | HARTBERGER, J. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-1 152 394 (RADIO CORP. OF AMERICA) * Figur 2; Seite 1, linke Spalte, Zeile 11 - Seite 1, rechte Spalte, Zeile 60; Seite 3, linke Spalte, Zeile 50 - Seite 3, rechte Spalte, Zeile 95 * | 1 | |
| A | EP-A-0 048 922 (TOKYO SHIBAURA DENKI K.K.) * Figuren 1,10; Seite 1, Zeilen 2-19 * | 4,5 | |
| A | EP-A-0 031 582 (TOKYO SHIBAURA DENKI K.K.) * Zusammenfassung; Figuren 5,13; Seite 5, Zeile 2 - Seite 6, Zeile 16; Seite 14, Zeile 2 - Seite 15, Zeile 12 * | 1,6,7 | |
| A | EP-A-0 150 481 (ITT) * Zusammenfassung; Figur 1 * | 1 | RECHERCHIERTE SACHGEBIETE (Int. Cl.4) |
| D,A | EP-A-0 055 795 (ITT) | | |

-----

Der vorliegende Recherchenbericht wurde für alle Patentansprüche erstellt.

| Recherchenort | Abschlußdatum der Recherche | Prüfer |
|---|---|---|
| DEN HAAG | 24-03-1987 | HARTBERGER, J. |